Europäisches Patentamt

(19) European Patent Office

Office européen des brevets

(11) Publication number: **0 139 479**
**B1**

(12) **EUROPEAN PATENT SPECIFICATION**

(45) Date of publication of patent specification: **16.09.87**

(21) Application number: **84306397.5**

(22) Date of filing: **19.09.84**

(51) Int. Cl.⁴: **G 03 C 1/76** // B01J13/02, B41M5/00

(54) **Emulsion useful in preparing radiation sensitive microcapsules, preparations of microcapsules and processes for forming the same, and imaging sheets.**

(30) Priority: **19.09.83 US 533087**

(43) Date of publication of application:
**02.05.85 Bulletin 85/18**

(45) Publication of the grant of the patent:
**16.09.87 Bulletin 87/38**

(84) Designated Contracting States:
**DE FR GB IT**

(56) References cited:
**DE-A-2 458 879**
**FR-A-2 100 209**
**FR-A-2 441 417**
**FR-A-2 516 269**

(73) Proprietor: **THE MEAD CORPORATION**
**Mead World Headquarters Courthouse Plaza Northeast**
**Dayton Ohio 45463 (US)**

(72) Inventor: **Marabella, Charles Peter**
**22 Shawnee Drive**
**Chillicothe Ohio, 45601 (US)**

(74) Representative: **Deans, Michael John Percy et al**
**Lloyd Wise, Tregear & CO. Norman House**
**105-109 Strand**
**London WC2R OAE (GB)**

## Description

In its various aspects, the present invention relates to preparations of microcapsules, to processes for forming microcapsules, and to imaging sheets.

Photosensitive imaging materials of the type which employ a layer of microcapsules containing a radiation sensitive composition have been described by us in U.S. Patent No: 4,399,209 and in British Patent Application No: 8232392 (Serial No: 2112536A). Imaging materials employing other types of photoactive microcapsules have also bee described in the Patent literature, though not necessarily put into practice. In particular:

Berman, U.S. Patent No. 3,219,446 discloses a transfer imaging process in which a blue-black dye is encapsulated with a photocrosslinkable polymer or a photopolymerizable monomer in a film or a layer of discrete microcapsules. In this system imaging is accomplished by image-wise exposing the layer of the encapsulated material to electromagnetic radiation to crosslink the polymer or polymerize the monomer. This is said to cause the liquid in the exposed capsules to assume a non-liquid, rigid condition, such that upon rupturing the capsules only the dye from the unexposed capsules is transferred to a receiving sheet where images are formed.

Phillips, U.S. Patent No: 3,700,439, discloses a process wherein Michler's-ketone is encapsulated in a conventional manner and provided as a layer on a support. Michler's ketone is not a colour former, but irradiation of the ketone converts it to a colourless, acid colourable, dye precursor. Thus, by image-wise exposing the Phillips material to actinic radiation and rupturing the capsules in contact with an acid developer layer, such as a layer of acid clay, a visible image is obtained in the areas in which the ketone has been converted to the acid colorable form by irradiation. Phillips also discloses a self-contained system in which the acid developer is on the same support as the capsules containing the Michler's ketone.

Levy, U.S. Patent No. 4,149,887, relates to a capsule-containing imaging material having a photoconductive internal phase which is exposed in an RF field. Exposure increases the conductivity of the internal phase and causes the capsules to heat, swell and then rupture in the exposed areas thereby freeing the contents to form images. The capsules may contain color precursors which form images by reacting with a developing agent.

Japanese Kokai, 6212/1974 to Matsushita Denki Sangyo K.K., relates to a recording material in which microcapsules having a photocrosslinkable polymer wall contain a colorless or substantially colorless precursor in a polar solvent and, optionally, an acid dye developer. The polar solvent prevents the color precursor from reacting with the acid dye developer and forming a color image. Images are formed by image-wise exposing the material to actinic radiation and rupturing the capsules in the unexposed areas, whereupon the polar solvent evaporates and color development occurs.

Japanese Kokai, 9519 and 9520/1978 to K. K. Rikoh, relate to imaging systems in which the capsules contain a radiation curable internal phase including a dye precursor. Images are formed by image-wise exposing a layer of the capsules to light and selectively transferring the capsules from the unexposed areas to a receiving sheet. The capsules are not ruptured. Upon subsequent wet development processing of the transfer sheet with a dye developer, the dye precursor in the capsules is converted to a coloured form and an image is obtained.

British Patent Nos. 1,001,832; 1,058,798; 1,141,475; and 1,193,923 to DuPont relate to imaging materials which employ a photopolymerizable substratum comprising a solid binder having a polymerizable ethylenically unsaturated compound dispersed therein. Images are formed by imagewise exposing the materials to actinic radiation. Exposure controls the rate of diffusion of a developer into or out of the photopolymerizable substratum. In the case of '798, a dye or color precursor is present in the capsules and images are formed by bringing a receiving sheet, such as plain or coated paper, into contact with a substratum and heating the two in combination such that the dye diffuses from the unexposed areas of the substratum to the receiving sheet. In the case of '475, at least one of a colour former, developer and oxidizing agent is present in the dispersed phase and the substratum is hardened in the exposed areas thereby altering the rate of diffusion of an externally applied reactant into the substratum.

In our aforesaid U.S. Patent 4399209 and British Patent Application 2112536A, images are formed by imagewise exposing a layer of photosensitive capsules to actinic radiation and rupturing the capsules typically by passing the imaging sheet containing the capsules through a pressure nip. The radiation sensitive composition contains a photohardenable or photosoftenable material which undergoes a change in viscosity upon exposure. For example, in the most typical embodiment, the radiation sensitive composition contains a polyethylenically unsaturated monomer which polymerizes upon exposure, thereby causing the phase internal to the capsules to become harder. Due to the difference in the hardness of the capsules in the exposed versus the unexposed areas, only certain capsules rupture and release their contents. If the internal phase contains a dye precursor, the precursor is image-wise released, and a colour image is formed upon its transfer to a developer layer. The developer layer may be present on the same support as the layer of capsules or a separate support. It is advantageous if the developer is present on the same support since such as self-containing imaging sheet can be developed as an integral unit.

One of the problems associated with self-contained imaging sheets is that smudging and pinpoints occur as the sheet is handled, packaged or stacked for storage. This is due to the capsules inadvertently rupturing and releasing the dye precursor which reacts with the developer present on the sheet. The problem intensifies if the capsules are too large and can be eliminated or substantially lessened if the capsules are reduced in size. However, previously it has only been possible to obtain capsules having the desired uniform small size using a certain dye precursor. This is not an acceptable solution to the problem, however, because it is often necessary to use other dye precursors in the capsules to form images of other colours or to improve the colour tone.

Thus, there is a need for improved microscapsules of uniform small particle size which are useful in providing a self-contained imaging sheet.

German Offenlegungsschrift 2458879 of Fuji Photo Film Co. Ltd. discloses the use of pectin as a hardening agent for microcapsules formed by complex coacervation. An oxidation product of pectin rather than pectin *per se* is used in the process. The oxidation product is added after the microcapsules are formed and consequently would not affect their particle size or uniformity.

French Patent Specification 2100209 also of Fuji Photo Film Co. Ltd. teaches the use of pectin as a shock preventing agent in the preparation of gelatin microcapsules. The purpose and function of the shock preventing agent is to prevent capsule agglomeration upon hardening of the capsules. Accordingly, and as taught in the French Patent Specification, the shock preventing agent is not added until after the microcapsules are formed. While the absence of agglomeration would improve particle size distribution, because the pectin is not added in the Fuji procedure until after the capsules are formed, it cannot serve to provide small uniform size microcapsules being formed.

French Patent Specification 2441417 of Kanzaki Paper Manufacturing Co. Ltd. relates to a process for producing microcapsules from an anion-modified amino-aldehyde resin wherein the microcapsules are formed in the presence of an anionic colloid. Among the colloids listed is pectic acid. The acid is obtained by hydrolyzing pectin, pectin being a methylated derivative of pectic acid. The object of using pectic acid or other anionic colloids is to achieve good water resistance and good solvent resistance. While there is a reference to an average particle size of 3.6 μm in the Kanzaki French Patent Specification, there is no suggestion anywhere in this document that the process is designed to lead or does in fact lead to uniformity in particle size.

Accordingly, none of the prior Patent proposals discussed hereinabove solves the evident need for improved microcapsules of uniform small particle size which can be used for providing a self-contained imaging sheet. The present invention is devoted to solving this problem.

As we shall explain in detail below, the photosensitive capsules of the present invention are prepared by emulsifying the radiation sensitive material in an aqueous medium. We have found that when pectin or another methylated polygalacturonic acid is dissolved in the aqueous medium, and the capsule wall is formed in an otherwise conventional manner, capsules of uniform small size are obtained. When these capsules are used in forming imaging sheets generally in the manner described in our aforementioned U.S. and British Patent Specifications, an increase in photographic gamma is often available.

According to a first aspect of the present invention, we provide a preparation of microcapsules having discrete capsules walls, the microcapsules containing a colour precursor and a radiation sensitive composition as the internal phase, and being formed from an oil-in-water emulsion, characterised in that the oil-in-water emulsion from which the capsules were formed contained methylated polygalacturonic acid as an emulsion stabilizer in the aqueous phase, and in that the capsules have a particle size selected without restriction upon the selection of colour precursor and defined as follows: an average particle size of about 4 to 8 μm, with not less than 90% of said capsules having a particle size less than 10 μm.

In a second and alternative aspect, the present invention provides a process for forming microcapsules having discrete capsule walls and containing a radiation sensitive material in the internal phase, comprising the steps of: forming an emulsion of said radiation sensitive composition in water using methylated polygalacturonic acid as an emulsion stabilizer in the aqueous phase of said emulsion; and forming a discrete capsule wall about the droplets of radiation sensitive material in said emulsion, thereby obtaining capsules having an average particle size of about 4 to 8 μm, not less than 90% of said capsules having a particle size less than 10 μm.

We have found that, because of their uniform small size, the capsules of the invention are particularly useful in forming self-contained imaging sheets where the presence of larger capsules often results in inadvertant, premature development in the form of smudging or background colouring.

Accordingly, the invention also extends to an imaging sheet comprising a support carrying on one surface thereof a layer of the microcapsules as aforesaid.

The principal example of an emulsion stabilizer used in the practice of the present invention is pectin, but other methylated polygalacturonic acids can also be used.

Self-contained imaging sheets in accordance with the present invention comprise a support, a layer of the aforesaid capsules, and a colour developer layer preferably interposed between the layer of capsules and the support. Transfer sheets generally consist of a layer of the capsules on a support. These sheets are exposed separately and then assembled with a sheet containing a dye developer on the surface for development.

The capsules may contain a photohardenable or a photosoftenable material, as the radiation sensitive material. In the most typical case, the capsules contain a polyethylenically unsaturated monomer, a photoinitiator, and a dye precursor. Imaging is conducted generally as described in our aforementioned U.S. and British Patent Specifications.

The term "methylation degree" as used herein refers to the ratio of acid groups in the compound which are methylated to the total number of acid groups in the compound expressed as a percentage.

The photosensitive microcapsules of the present invention are prepared from an aqueous based emulsion of a radiation sensitive composition containing methylated polygalacturonic acid in the aqueous phase. Methylated polygalacturonic acids are generally available having a methylated degree in the range of about 50 to 75%. The preferred polygalacturonic acids have a methylation degree in excess of about 50% and more preferably about 60 to 75%. However, acids having a methylation degree less than 50% and greater than 75% are also believed to be useful. The most typical examples of useful acids are commonly known as pectins. Polygalacturonic acid is generally added to the aqueous phase in an amount of about 1.0 to 8% based on the amount of water in the external phase, with the preferred amount being about 2 to 4%.

Emulsification is preferably conducted under conditions which afford an emulsion having an average particle size in the range of about 8 to 12 microns. The observed particle size of the emulsion is somewhat larger than the particle size of the capsules produced in accordance with the invention. Typically, the emulsion is prepared by adding an oily phase containing the radiation sensitive composition to an aqueous phase containing methylated polygalacturonic acid while stirring or otherwise agitating the aqueous phase to achieve the desired emulsion particle size. The aqueous phase may also include other capsule wall forming materials in a manner well known in the art.

The capsule wall can be formed around the radiation-sensitive oil droplets in the emulsion using many known wall forming techniques including coaceration, interfacial polymerization and the like. See for example, Green et al, U.S. Patents Nos. 2,730,456 and 2,800,457 for forming gelatin capsules; Hart et al, U.S. Patent No. 3,755,190 for resorcinol-formaldehyde capsules; Vassiliades, U.S. Patent No. 3,914,511 for isocyanate capsules; Kiritani et al, U.S. Patent No. 3,796,669 for urea-resorcinol-formaldehyde capsules; Forris et al, U.S. Patents Nos. 4,001,140; 4,087,376 and 4,089,802 for melamine-formaldehyde capsules and U.S. Patent No. 4,025,455 to Shackle for hydroxypropyl cellulose capsules.

The present invention can be practiced using the aforesaid techniques by incorporating pectin in the aqueous phase prior to emulsification of the oil. The preferred wall former for use in the present invention is urea-formaldehyde copolymer or urea-resorcinol-formaldehyde copolymer. In accordance with the latter embodiment of the invention capsules can be prepared by forming an aqueous phase containing pectin, and adjusting the pH to about 4.0, followed by the addition of the oil phase containing the radiation sensitive composition, both phases being previously heated to about 60°C. Blending is continued until an average emulsion particle size of about 10 microns has been achieved whereupon urea, resorcinol and formalin solutions are added to the emulsion and the capsule walls gradually form.

The radiation-sensitive compositions used in the present invention undergo a change in viscosity upon exposure to actinic radiation. "Actinic radiation" includes the entire electromagnetic spectrum (e.g., U.V., I.R., Visible), X-ray and ion beam radiation. These compositions may be positive working or negative working. For example, where the radiation sensitive composition contains a photohardenable material, such as, a photopolymerizable or photocrosslinkable material, in the exposed areas the internal phase solidifies or increases in viscosity and thereby prevents the capsules from rupturing and releasing the image forming agent (e.g., a color precursor) associated with the capsules. In the unexposed areas, the internal phase remains liquid, the capsules rupture, and the image-forming agents are mobilized. In this manner positive images are formed. On the other hand, where the capsules contain a photosoftenable material, such as a photodepolymerizable material, exposure reduces the viscosity of the internal phase and the elements active in the image-forming process are released in the exposed areas whereby negative images are formed.

Typical positive-working radiation sensitive compositions include a photoinitiator and a monomer, dimer, or oligomer which is polymerized to a higher molecular weight compound, or a polymer which is cross-linked upon exposure. Ethylenically unsaturated organic compounds are particularly useful. These compounds contain at least one terminal ethylene group per molecule. Typically, they are liquid and can double as a diluent oil for the internal phase. Ethylenically unsaturated compounds having two or more terminal ethylene groups per molecule are preferred. An example of this preferred subgroup are ethylenically unsaturated acid esters of polyhydric alcohols, such as trimethylol propane triacrylate (TMPTA).

Another suitable radiation sensitive composition is an acrylate prepolymer derived from the partial reaction of pentaerythritol with acrylic acid or acrylic acid esters. Photosensitive compositions based on these prepolymers having an acrylate functionality of between approximately two and three are available commerically in two-package systems from the Richardson Company, Melrose Park, Illinois.

Another group of substances useful as radiation sensitive compositions include isocyanate modified acrylic, methacrylic and itaconic acid esters of polyhydric alcohols are disclosed in U.S. Patent Nos. 3,783,151; 3,759,809 and 3,825,479, all to Carlick et al. Radiation curable compositions including isocyanate modified esters and reactive diluents are commercially available as over print varnishes from Sun Chemical Corp., Carlstat, New Jersey, under the tradename of Sun Cure resins.

An example of negative working radiation depolymerizable materials that may be useful in the invention are 3-oximino-2-butanone methacrylate which undergoes main chain scission upon U.V. exposure and poly 4'-alkyl acylophenones. See Reichmanis, E.; *Am. Chem. Soc. Div. Org. Coat. Plast. Chem. Prepr.* 1980. *43*, 243—251 and Lukac, I.; Chmela S., Int. Conf. on Modif. Polym. 5th. Bratislave, Czech. July 3—6, 1979, I.U.P.A.C. Oxford, England 1979, *1*, 176—182.

A photoinitiator is generally also required in the radiation sensitive composition. Numerous examples of suitable imaging initiators can be found in the literature. Examples of photoinitiators useful in the present invention include diaryl ketone derivatives, and benzoin alkyl ethers. Where ultraviolet sensitivity is desired, suitable photoinitiators include alkoxy phenyl ketones, O-acylated oximinoketones, polycyclic quinones, benzophenones and substituted benzophenones, xanthones, thioxanthones, halogenated compounds such as chlorosulfonyl and chloromethyl polynuclear aromatic compounds, chlorosulfonyl and chloromethyl heterocyclic compounds, chlorosulfonyl and chloromethyl benzophenones and fluorenones, and haloalkanes. In many cases it is advantageous to use a combination of imaging photoinitiators. For ultraviolet sensitivity one desirable combination is a combination of Michler's ketone and benzoin methyl ether (preferred ratio 2:5). Another useful combination is 2,2'-dimethoxy-2-phenylacetophenone, isopropylxanthone and ethyl paradimethylamino-benzoate. The latter is preferably used with TMPTA to provide a radiation sensitive composition.

The amount of photoinitiator in the radiation sensitive composition depends on the particular photosensitive material selected. It must be present in an amount sufficient to initiate polymerization or cross-linking within a short exposure time.

The radiation sensitive composition must make up a large enough proportion of the internal phase to effectively control the release of the image-forming agent following exposure. This generally means that the radiation sensitive material must constitute approximately 40 to 99% by weight of the internal phase of the capsules.

In the most typical case, colour images are formed by image-wise releasing a colour precursor from the capsules. In this case, in addition to the radiation sensitive composition, the internal phase usually includes the colour precursor. Typical examples of colour precursors useful in the present invention include colourless electron donating type compounds. Representative examples of such colour formers include substantially colourless compounds having in their partial skeleton a lactone, a lactam, a sultone, a spiropyran, an ester or an amido structure such as triarylmethane compounds, bisphenylmethane compounds, xanthene compounds, fluorans, thiazine compounds, spiropyran compounds and the like. Crystal Violet Lactone and Copikem IV and XI ("Copikem" is a Trade Mark of Hilton-Davis Chemical Co.) are often used alone or in combination as colour precursors in the present invention. Numerous other examples can be found in the carbonless paper art.

Colour precursors represent only one type of image-forming agent which may be incorporated in or otherwise associated with the capsules of the present invention. Depending on the nature of the imaging material, other image-forming agents including coloured dyes, pigments, metal salts and chelating agents may be incorporated into the capsules. The image-forming agent can be incorporated in a separate layer of the imaging sheet instead of in the capsules and activated by the release of the internal phase from the capsules. For example, the released internal phase may act as a solvent for an image-forming agent otherwise associated with the capsules.

Useful color developer materials for preparing the self-contained sheets of the present invention are clay minerals such as acid clay, active clay, attapulgite, etc.; organic acids such as tannic acid, gallic acid, propyl gallate, etc.; acid polymers such as phenyl-formaldehyde resins, phenol acetylene condensation resins, condensates between an organic carboxylic acid having at least one hydroxy group and formaldehyde, etc.; metal salts or aromatic carboxylic acids such as zinc salicylate, tin salicylate, zinc 2-hydroxy naphthoate, zinc 3,5 di-tert butyl salicylate, oil soluble metal salts or phenol-formaldehyde novolak resins (e.g., see U.S. Patent Nos. 3,673,935; 3,732,120 and 3,737,410) such as zinc modified oil soluble phenol-formaldehyde resin as disclosed in U.S. Patent No. 3,732,120, zinc carbonate etc. and mixtures thereof. These compounds are generally referred to as electron accepting type compounds.

Any ordinary coating or printing technique may be used to make the imaging sheets of the present invention. The techniques described in U.S. Patent No. 4,010,292 are useful in preparing self-contained sheets.

The substrate upon which the capsules are coated may be paper (e.g., commercial impact raw stock, cast-coated paper, chrome-rolled paper, etc.), foil, or a plastic substrate (e.g., a PET film). High quality papers are preferred because, due to the small size of the capsules of the present invention, they can become embedded in the stock fibers and prevented from rupturing upon exposure and development.

In addition to a radiation-sensitive composition and a color precursor, the internal phase may also include a dilulent oil to adjust the tonal properties of the imaging sheet (i.e., the transfer sheet or the self-contained-sheet). Representative examples of useful diluent oils are alkylated biphenyls (e.g., monoisopropylbiphenyl), polychlorinated biphenyls, castor oil, mineral oil, deodorized kerosene, naphthenic mineral oils, dibutyl phthalate, dibutyl fumerate, brominated paraffin and mixtures thereof. Alkylated biphenyls are generally less toxic and preferred.

Other protective colloids can be used in preparing the capsules, in combination with pectin or another methylated polygalacturonic acid, to achieve improved properties. For example, some anionic colloids such as maleic anhydride copolymer can be used as modifiers in encapsulation processes in which urea-formaldehyde, melamine-formaldehyde or the like is used as the wall former. It is particularly advantageous to use isobutylene-maleic anhydride copolymer (e.g., Isobam No: 10) in combination with pectin.

Imaging sheets incorporating the photosensitive capsules of the present invention are used by image-wise exposing them to actinic radiation and rupturing the capsules. As explained in our aforementioned British and United States Patent Specifications, it is likely that images are formed by a combination of mechanisms whereby more capsules rupture in the exposed or unexposed areas depending upon whether the imaging material is a positive working or a negative working material, and the capsules which rupture release their contents in proportion to the degree of exposure. Reference may be made to U.S. Patent No: 4,399,209 to Sanders et al for a discussion of imaging mechanics. The capsules are usually ruptured by pressure (e.g., by passing the exposed sheet through pressure rolls), but may also be ruptured by other means such as solvent vapour, ultrasound, abrasion, and the like.

The present invention is illustrated in more detail by the following non-limiting examples.

1. Preparation of isobam-10 solution:

To 113.5 litres (30 gallons) of water under agitation is slowly added 19.96 kg (44 lbs.) of Isobam-10 powder. Isobam is an acronym for isobutylene-maleic anhydride copolymer. Upon sufficient dispersion 7.26 kg (16 lbs.) of sodium. hydroxide (powder) is slowly added, and the resultant suspension is heated at 93°C for 2 hours. The final solution is brought to room temperature (20% solids).

2. Preparation of continuous phase:

A vessel equipped with a speed controllable mixer is charged with 90.0 g. of the aforementioned hydrolyzed Isobam-10 aqueous solution, 235.0 g. of a 5.3% aqueous solution of pectin and 200.0 g water. The pH is then adjusted to 4.0.

3. Preparation of internal phase:

To 200.0 g, trimethylolpropanetriacrylate is added, with mild heating, 12.0 g. Copikem IV, 48.0 g. Irgacure 651, 4.0 g. Quanticure ITX, and 4.0 g. Quanticure EPD. "Irgacure" is a Trade Mark of Ciba-Geigy Corp. used for a family of photoinitiators. "Quanticure" is a Trade Mark of Blenkinsop & Co. Ltd. Quanticure ITX is isopropyl thioxanthone. Quanticure EPD is ethyl p-dimethy- laminobenzoate. The resulting solution is cooled and slowly added to the continuous phase with sufficient agitation to yield oil droplets in the range of 10 μm.

4. Capsule preparation

33.2 g, urea in 50 ml water, 3.2 g. resorcinol in 25 ml water, 85.6 g. of 37% aqueous formaldehyde, and 2.4 g. ammonium sulfate in 25 ml water are added to the emulsion obtained in step 3 above. The temperature of the combined mixture is raised to 65°C and held for 2 hours. Upon discontinuing heating, the pH of the slurry is adjusted to 9.0, sodium bisulfite (11.2 g in 25 ml water) is added, and after 0.5 hour, agitation is discontinued. This preparation consistently yields microcapsules with an average diameter in the range of 4 to 8 microns and not less than 96% of the microcapsules are less than 10 microns in size.

Example 1 above was repeated except the aqueous pectin solution was replaced with 10% gum arabic solution (123.0 g) in the continuous phase. This preparation did not yield microcapsule populations with an average diameter less than 15.0 microns, and the distribution ranged from submicron to 100 microns in size.

Having described the invention in detail and by reference to specific embodiments thereof, it will be apparent that numerous modifications and variations are possible without departing from the scope of the invention.

## Claims

1. A preparation of microcapsules having discrete capsule walls, the microcapsules containing a colour precursor and a radiation sensitive composition as the internal phase, and being formed from an oil-in-water emulsion, characterised in that the oil-in-water emulsion from which the capsules were formed contained methylated polygalacturonic acid as an emulsion stabilizer in the aqueous phase, and in that the capsules have a particle size selected without restriction upon the selection of colour precursor and defined as follows: an average particle size of about 4 to 8 μm, with not less than 90% of said capsules having a particle size less than 10 μm.

2. A preparation according to Claim 1, further characterised in that said discrete capsule wall is formed from urea-formaldehyde resin.

3. A preparation according to Claim 1 or Claim 2, further characterised in that said radiation sensitive composition includes a polyethylenically unsaturated monomer and a photoinitiator.

4. A preparation according to any preceding claim, further characterised in that said polygalacturonic acid is pectin.

5. An imaging sheet comprising a support carrying on one surface thereof a layer of microcapsules according to any preceding claim.

6. An imaging sheet according to Claim 5, further characterised in that said sheet comprises a layer containing a colour developer material.

7. A process for forming microcapsules having discrete capsules walls and containing a radiation sensitive material in the internal phase, comprising the steps of: forming an emulsion of said radiation sensitive composition in water using methylated polygalacturonic acid as an emulsion stabilizer in the aqueous phase of said emulsion; and forming a discrete capsule wall about the droplets of radiation sensitive material in said emulsion, thereby obtaining capsules having an average particle size of about 4 to 8 µm, not less than 90% of said capsules having a particle size less than 10 µm.

8. A process according to Claim 7, wherein said discrete capsule wall is a urea-formaldehyde resin.

9. A process according to Claims 7 or 8, wherein said radiation sensitive material comprises a polyethylenically unsaturated monomer and a photoinitiator.

10. A process according to any of Claims 7, 8 or 9, wherein said polygalacturonic acid is pectin.

## Patentansprüche

1. Mikrokapsel-Präparat mit diskreten Wandungen der Kapsel, wobei die Mirkokapseln eine Farbvorstufe (colour precursor) une ein strahlungsempfindliches gemischtes Material als Zwischenphase enthalten und aus einer Öl-in-Wasser-Emulsion gebildet wurden, dadurch gekennzeichet, daß die Öl-in-Wasser-Emulsion, aus der die Kapseln gebildet wurden, methylierte polygalakturonische Säure åls einen Emulsionsstabilisator in der wäßrigen Phase enthielt, und dadurch, daß die Kapseln eine Teilchengröße haben, die ohne Einschränkung in Bezug auf die Auswahl der Farbvorstufe ausgewählt ist und wie folgt definiert ist: eine Durchschnitts-Partikelgröße von etwa 4—8 µm, wobei nicht weniger als 90% der Kapseln eine Partikelgröße von weniger als 10 µm haben.

2. Präparat nach Anspruch 1, weiterhin dadurch gekennzeichnet, daß die diskrete Kapselwandung aus einem Harnstoff-Formaldehyd-Kunststoff gebildet ist.

3. Präparat nach Anspruch 1 oder Anspruch 2, weiterhin dadurch gekennzeichnet, daß das strahlungsempfindliche Material ein polyethylenisch ungesättigtes Monomer und einen Photoinitiator enthält.

4. Herstellung nach einem der vorherigen Ansprüche, weiterhin dadurch gekennzeichnet, daß die genannte polygalakturonische Säure Pectin ist.

5. Bild-Blatt (imaging sheet) mit einem Substrat, welches auf einer seiner Oberflächen eine Schicht von Mikrokapseln entsprechend einem der vorhergehenden Ansprüche trägt.

6. Bild-Blatt nach Anspruch 5, weiterhin dadurch gekennzeichnet, daß das besagte Blatt eine Schicht umfaßt, die einen Farb-Entwickler enthält.

7. Verfahren zur Herstellung von Mikrokapseln, die diskrete Kapselwandungen haben und ein strahlungsempfindliches, gemischtes Material als Zwischenphase enthalten, wobei das Verfahren folgende Schritte umfaßt:

Herstellung einer Emulsion des strahlungsempfindlichen Materials in Wasser, wobei methylierte polygalakturonische Säure als ein Emulsionsstabilisator in der wäßrigen Phase der Emulsion verwandt wird;

Bildung einer diskreten Kapselwandung um die Tröpfchen des strahlungsempfindlichen Materials in der genannten Emulsion, wobei Kapseln gewonnen werden, die eine Durchschnitts-Teilchengröße von etwa 4—8 µm haben, wobei nicht weniger als 90% der besagten Kapseln eine Teilchengröße von weniger als 10 µm besitzen.

8. Verfahren nach Anspruch 7, dadurch gekennzeichnet, daß die diskrete Kapselwandung ein Harnstoff-Formaldehyd-Kunststoff ist.

9. Verfahren nach Anspruch 7 oder 8, dadurch gekennzeichnet, daß das strahlungsempfindliche Material ein polyethylenisch ungesättigtes Monomer und einen Photoinitiator enthält.

10. Verfahren nach einem der Ansprüche 7, 8 oder 9, dadurch gekennzeichnet, daß die genannte polygalakturonische Säure Pectin ist.

## Revendications

1. Une préparation de microcapsules ayant des parois de capsule discontinues, les microcapsules contenant un précurseur de couleur et une composition sensible aux radiations comme phase interne, et étant formées à partir d'une émulsion huile-dans-eau, caractérisé en ce que l'émulsion huile-dans-eau à partir de laquelle sont formées les capsules, contient un acide polygalacturonique méthylé comme stabilisateur d'émulsion dans la phase aqueuse, et en ce que les capsules ont une dimension de particule choisie sans restriction à la sélection du précurseur de couleur et définie comme suit: une dimension moyenne de particule d'environ 4 à 8 µm, 90% au moins desdites capsules ayant une dimension de particule inférieure à 10 µm.

2. Une préparation selon la revendication 1, caractérisée en outre en ce que ladite paroi de capsule discontinue est formée à partir d'une résine urée-formaldéhyde.

3. Une préparation selon la revendication 1 ou la revendication 2, caractérisée en outre en ce que ladite composition sensible aux radiations comprend un monomère à insaturation polyéthylénique et un photoinitiateur.

4. Une préparation selon l'une quelconque des revendications précédentes, caractérisée en outre en ce que ledit acide polygalacturonique est la pectine.

5. Une feuille formatrice d'image comprenant un support portant sur l'une de ses faces une couche de microcapsules selon l'une quelconque des revendications précédentes.

6. Une feuille formatrice d'image selon la revendication 5, caractérisée en outre en ce que ladite feuille comprend une couche contenant un matériau développateur de la couleur.

7. Un procédé de formation de microcapsules ayant des parois de capsule discontinues et contenant un matériau sensible aux radiations dans la phase interne, comprenant les étapes suivantes: formation d'une émulsion de ladite composition sensible aux radiations dans l'eau en utilisant un acide polygalacturonique méthylé comme stabilisateur d'émulsion dans la phase aqueuse de ladite émulsion; et formation d'une paroi de capsule discontinue autour des gouttes de composition sensible aux radiations dans ladite émulsion, obtenant ainsi des capsules ayant une dimension moyenne de particule d'environ 4 à 8 µm, 90% au moins desdites capsules ayant une dimension de particule inférieure à 10 µm.

8. Un procédé selon la revendication 7, caractérisé en ce que ladite paroi de capsule discontinue est une résine urée-formaldéhyde.

9. Un procédé selon la revendication 7 ou 8, caractérisé en ce que ladite matériau sensible aux radiations comprend un monomère à insaturation polyéthylénique et un photoinitiateur.

10. Un procédé selon l'une quelconque des revendications 7, 8 ou 9, caractérisé en ce que ledit acide polygalacturonique est la pectine.